**Europäisches Patentamt**

**European Patent Office**

**Office européen des brevets**

(19)

(11) Veröffentlichungsnummer : **0 523 048 B1**

(12)

# EUROPÄISCHE PATENTSCHRIFT

(45) Veröffentlichungstag der Patentschrift :
29.12.93 Patentblatt 93/52

(51) Int. Cl.⁵ : **G01R 15/07**

(21) Anmeldenummer : **90917922.8**

(22) Anmeldetag : **12.07.90**

(86) Internationale Anmeldenummer :
**PCT/DE90/00530**

(87) Internationale Veröffentlichungsnummer :
**WO 91/01500 07.02.91 Gazette 91/04**

(54) **FASEROPTISCHE ANORDNUNG ZUM MESSEN DER STÄRKE EINES ELEKTRISCHEN STROMES.**

(30) Priorität : **19.07.89 DE 3923803**

(43) Veröffentlichungstag der Anmeldung :
**20.01.93 Patentblatt 93/03**

(45) Bekanntmachung des Hinweises auf die
Patenterteilung :
**29.12.93 Patentblatt 93/52**

(84) Benannte Vertragsstaaten :
**AT BE CH DE DK ES FR GB IT LI LU NL SE**

(56) Entgegenhaltungen :
**CH-A- 591 085
CH-A- 659 329
DE-A- 3 115 433
DE-C- 2 924 804
FR-A- 2 475 230
GB-A- 2 104 213
GB-A- 2 164 146**

(56) Entgegenhaltungen :
**Patent Abstracts of Japan, Band 11, Nr. 399,
P651, Zusammenfassung von JP-62-161059
Patent Abstracts of Japan, Band 8, Nr 137,
P282, Zusammenfassung von JP-59-38663
Patent Abstracts of Japan, Band 10, Nr 288,
P502, Zusammenfassung von JP-61-107169**

(73) Patentinhaber : **MWB MESSWANDLER-BAU
AG
Nürnberger Strasse 199
D-96050 Bamberg (DE)**

(72) Erfinder : **PEIER, Dirk
Am Talenberg 49
D-4600 Dortmund 50 (DE)**
Erfinder : **HIRSCH, Holger
Bönener Strasse 40
D-4703 Bönen (DE)**

(74) Vertreter : **Hufnagel, Walter, Dipl.-Ing.,
Dipl.-Wirtsch.-Ing. et al
Dorner & Hufnagel Patentanwälte Bad
Brückenauer Str. 19
D-90427 Nürnberg (DE)**

EP 0 523 048 B1

**Beschreibung**

Die Erfindung betrifft eine faseroptische Anordnung zum Messen der Stärke eines elektrischen Stromes unter Ausnutzung des Faraday-Effekts, wobei das den stromdurchflossenen Leiter umgebende Magnetfeld den Polarisationszustand des Lichts beeinflußt, dessen Weg durch den Kern einer optischen Faser führt, die den Leiter in Form einer Wicklung umgibt, wobei das aus der optischen Faser ausgekoppelte Licht durch einen Strahlteiler in zwei Teillichtstrahlen aufgeteilt wird, deren Intensitäten nach Durchlaufen je eines Polarisators mit je einem Photodetektor gemessen werden.

Derartige Anordnungen werden insbesondere in Hochspannungsanlagen eingesetzt, um Ströme in auf Hochspannungspotential liegenden Leitungen zu messen. Da die Lichtwellenleiter aus Glas bestehen, das bekanntlich ein guter elektrischer Isolator ist, gibt es keine Probleme bezüglich der Isolierung der mit Erdpotential verbundenen Anzeigegeräte gegenüber den auf Hochspannungspotential liegenden Leitern, deren Strom gemessen und angezeigt werden soll.

Aus der DE-AS 22 61 151 ist eine Anordnung bekannt, bei der von einer Lichtquelle Licht durch einen Polarisator auf eine halbdurchlässige Platte gelenkt wird.

Von dort gelangt das polarisierte Licht in eine optische Faser (dort "Lichtwellenleiter" genannt), die teilweise zu einer Spule gewickelt ist, in deren Achse ein Hochspannungsleiter verläuft, in welchem der zu messende Strom fließt. Diese Faserspule ist an ihrem Ende mit einer verspiegelten Flache versehen oder es ist dort ein Spiegel angeordnet. Das polarisierte Licht durchläuft die gesamte optische Faser, wobei innerhalb des spulenförmigen Teils der Faser aufgrund des Faraday-Effekts eine Drehung der Polarisationsebene in Abhängigkeit von dem Magnetfeld erfolgt, das der in dem Leiter fließende Strom erzeugt. Am Ende der Spule wird der Lichtstrahl reflektiert und durchläuft noch einmal die Spule, wobei eine weitere Drehung der Polarisationsebene eintritt. Das in seiner Polarisationsebene gedrehte Licht tritt aus der optischen Faser aus, durchsetzt die halbdurchlässige Platte und gelangt in eine Auswerteeinrichtung, die den Winkel zwischen der Polarisationsebene des in die optische Faser eintretenden Lichts und der Polarisationsebene des aus der Faser austretenden Lichts feststellt und anzeigt, wobei die Größe dieses Winkels dem Wegintegral über der magnetischen Feldstärke proportional ist.

Aus der DE-AS 28 35 794 ist ebenfalls eine faseroptische Anordnung zum Messen der Stärke eines elektrischen Stromes unter Ausnutzung des Faraday-Effekts bekannt, wobei das den stromdurchflossenen Leiter umgebende Magnetfeld den Polarisationszustand des Lichts beeinflußt, dessen Weg durch den Kern einer optischen Faser führt, die den Leiter in Form einer Wicklung umgibt. Im Gegensatz zu der DE-AS 22 61 151 ist bei dieser Anordnung an dem einen Ende der Faser keine reflektierende Fläche vorgesehen, vielmehr wird das Licht an dem einen Ende eingekoppelt und an dem anderen wieder ausgekoppelt, wobei die aus der optischen Faser gewickelte Spule die doppelte Windungszahl haben muß, um die gleichen Drehwinkel der Polarisationsebene zu erhalten, weil die Spule nur einmal von dem Licht durchlaufen wird.

In beiden vorstehend erwähnten Fällen besteht die Auswerteeinrichtung aus einem Analysator- bzw. aus einem Wollaston-Prisma, das das ausgekoppelte Licht in zwei Teillichtstrahlen aufteilt, deren Polarisationsebenen senkrecht aufeinander stehen und deren Intensitäten mit zwei Photodetektoren gemessen werden, deren Photoströme dann

$$I_1 = I_0 \cdot (1 + \sin 2\theta)$$

und

$$I_2 = I_0 \cdot (1 - \sin 2\theta)$$

sind, wobei der Winkel $\theta$ gemäß

$$\theta = V \cdot N \cdot I$$

proportional ist. Die Anzahl der Windungen der optischen Faser um den stromführenden Leiter ist N. Die materialabhängige Proportionalitätskonstante ist durch

$$V = 2{,}6 \cdot 10^{-6} \text{ rad/A}$$

gegeben. Aus den beiden Photoströmen wird dann gemäß

$$U_A = \frac{I_1 - I_2}{I_1 + I_2} = \sin 2\theta = \sin 2 \cdot V \cdot N \cdot I$$

das Ausgangssignal $U_A$ gewonnen, das sinusförmig von dem zu messenden Strom abhängt.

Um den Aufwand an Berechnungen, die in Echtzeit erfolgen müssen, gering zu halten, wird der Sensor so bemessen, daß der stromabhängige Winkel $\theta$ klein bleibt. Dann kann die Sinusfunktion linear angenähert werden, weil der Sinus eines kleinen Winkels etwa gleich diesem Winkel ist.

Außerdem können sehr große Ströme, zum Beispiel Kurzschlußströme, die eine Drehung der Polarisationsebene des Lichts von mehr als 45° hervorrufen, mit den beschriebenen Verfahren nicht detektiert werden, weil die Sinusfunktion nur innerhalb des Winkelbereichs von -90° bis +90° umkehrbar eindeutig ist. Deshalb wird zum Beispiel bei einem bekannten Verfahren nach der DE-AS 25 41 072 mit einer gesonderten Kompensationsspule und einer Regelschleife die Drehung der Polarisationsebene wieder rückgängig gemacht. Aufgrund unvermeidbarer Stellgrößenbeschränkung der Stromendstufen sind die Dynamik und die Bandbreite sehr klein. Außerdem steht der hohe Energieverbrauch dieser Endstufen dem Einsatz dieses Konzeptes entgegen.

Der Erfindung liegt die Aufgabe zugrunde, eine faseroptische Anordnung der eingangs erwähnten Art zu schaffen, die ohne erhöhten Energiebedarf einen erweiterten Strombereich zu detektieren gestattet.

Diese Aufgabe wird nach dem Kennzeichen des Anspruchs 1 dadurch gelöst, daß die Polarisatoren symmetrisch zueinander gegenüber dem herkömmlichen Winkel von 45° verdreht sind.

Nach einer vorteilhaften Ausgestaltung der Erfindung wird der Winkel zwischen den Polarisatoren und der Polarisationsebene des in die optische Faser eingekoppelten Lichts zwischen +20° und +40° bzw. zwischen -20° und -40° gewählt.

Die mit der Erfindung erzielten Vorteile bestehen insbesondere darin, daß die lineare Näherung der Ausgangsspannung $U_A$ für wesentlich größere Drehungen der Polarisationsebene gültig ist. Die Dynamik wird folglich gegenüber der Auswertung in den bekannten Anordnungen vergrößert. Durch die zusätzliche rechnergestützte Auswertung, die direkt die Photoströme $I_1$ und $I_2$ aufgreift, ist eine Drehung der Polarisationsebene von über 45° noch detektierbar.

Ein Ausführungsbeispiel ist in der Zeichnung dargestellt und wird im folgenden näher beschrieben.

Es zeigen

Fig. 1  einen schematischen Aufbau der erfindungsgemäßen Anordnung und

Fig. 2  eine Funktionsdarstellung des Ausgangssignals einer Auswerteeinrichtung der erfindungsgemäßen Anordnung in Abhängigkeit von dem Drehwinkel $\theta$ der Polarisationsebene.

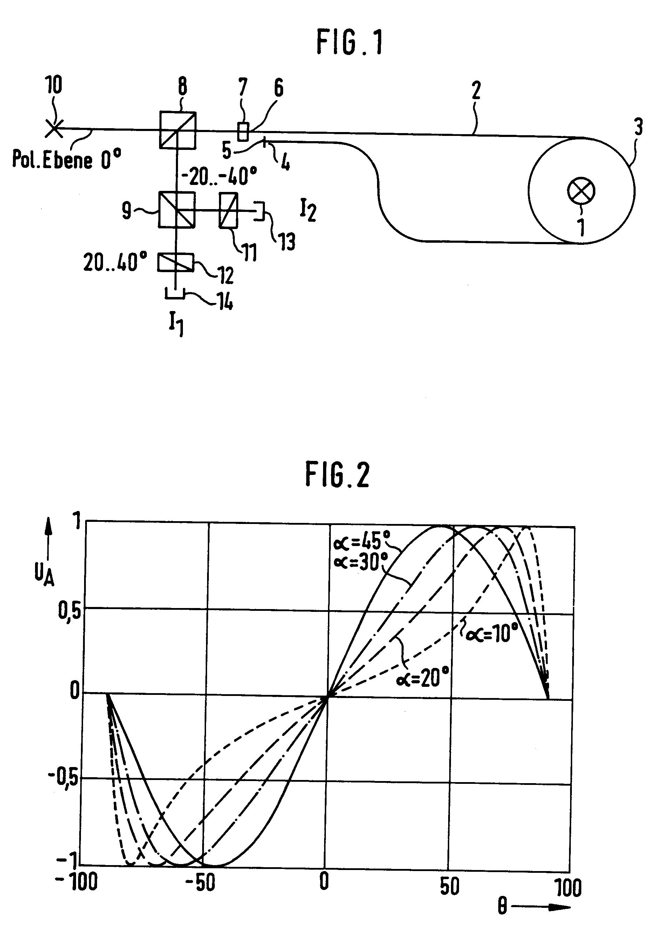

Die faseroptische Anordnung nach Fig. 1 zum Messen der Stärke eines elektrischen Stromes besteht aus einer optischen Faser 2, die sich von ihrem einen Ende 6, das an einer Linse 7 angeordnet ist, zu einem auf Hochspannungspotential liegenden Leiter 1 erstreckt, diesen Leiter 1 als Wicklung 3 mit einer Anzahl nebeneinander angeordneter Windungen umgibt und wieder zurück in die Nähe der Linse 7 verläuft, wo ihr Ende 4 eine verspiegelte Fläche 5 aufweist, die rechtwinklig zu der Faserlängsachse ausgerichtet ist.

Die Linse 7 koppelt das über einen Strahlteiler 8 kommende, von einem Laser 10 ausgestrahlte, polarisierte Licht in das eine Ende 6 der optischen Faser 2 ein. Innerhalb des zur Wicklung 3 geformten Teils der optischen Faser 2 ist der Lichtwellenleiter einem Magnetfeld ausgesetzt, das von dem durch den Leiter 1 fließenden Strom erzeugt wird. Aufgrund des Faraday-Effekts wird die Polarisationsebene des geführten Lichts während des Durchlaufens der Wicklung 3 und somit des Magnetfeldes gedreht, wobei die Größe des Drehwinkels ein Maß für das Wegintegral über der magnetischen Feldstärke ist.

Hinter der Wicklung 3 gelangt das Licht weiter über die optische Faser bis zu ihrem anderen Ende 4, wo es an der verspiegelten Endfläche 5 reflektiert wird, so daß es den Weg durch die optische Faser 2 und durch das Magnetfeld im Bereich der Wicklung 3 in entgegengesetzter Richtung durchläuft, wobei die Polarisationsebene abermals gedreht wird, so daß der Drehwinkel der Polarisationsebene beim Eintreffen des Lichts an der Linse 7 gegenüber dem Drehwinkel beim Eintreffen des Lichts an der verspiegelten Endfläche 5 insgesamt verdoppelt ist.

Die Ein- und Auskopplung des Lichts erfolgt über die Linse 7. Beim Auskoppeln gelangt das Licht aus der optischen Faser 2 über den Strahlteiler 8 zu einer Auswerteeinrichtung, die aus einem weiteren Strahlenteiler 9, aus zwei Polarisatoren 11, 12 und zwei Photodetektoren 13, 14 besteht, in der der Drehwinkel ermittelt wird, den die Polarisationsebene des Lichts beim Durchgang durch die optische Faser 2 erfahren hat und der ein Maß für die Stärke des in dem Leiter 1 fließenden elektrischen Stromes ist.

Die Polarisatoren 11, 12 sind symmetrisch zueinander gegenüber dem herkömmlichen Winkel von 45° verdreht, und zwar so, daß der Winkel zwischen den Polarisatoren 11, 12 und der Polarisationsebene des in die optische Faser 2 eingekoppelten Lichts zwischen +20° und +40° bzw. zwischen -20° und -40° liegt. Mit diesem Polarisatorwinkel $\alpha$ sind die Photoströme

$$I_1 = I_0 \cdot (1 + \cos(2\theta + 2\alpha))$$

und

$$I_2 = I_0 \cdot (1 + \cos(2\theta - 2\alpha)).$$

Das Ausgangssignal $U_A$ wird in der oben erwähnten Weise aus den Photoströmen ermittelt. Das Ergebnis sind die Kurven in Fig. 2, die das Ausgangssignal $U_A$ als Funktion des Drehwinkels $\theta$ der Polarisationsebene für verschiedene Winkelstellungen $\alpha$ der Polarisatoren 11, 12 wiedergeben. Wie aus der Fig. 2 zu ersehen ist, ist die Abhängigkeit des Ausgangssignals $U_A$ von der zu dem zu messenden Strom proportionalen Drehung $\theta$ der Polarisationsebene bei Polarisatorwinkeln $\alpha$ zwischen 20° und 40° weitgehend linearisiert. Die lineare Näherung des Ausgangssignals $U_A$ ist für wesentlich größere Drehungen der Polarisationsebene gültig. Folglich ist die Dynamik gegenüber der herkömmlichen Auswertung vergrößert. Durch eine zusätzliche rechnergestützte Auswertung, die direkt die Photoströme $I_1$ und $I_2$ aufgreift, ist auch eine Drehung der Polarisationsebene von über 45° noch detektierbar.

## Patentansprüche

1. Faseroptische Anordnung zum Messen der Stärke eines elektrischen Stromes unter Ausnutzung des Faraday-Effekts, wobei das den stromdurchflossenen Leiter (1) umgebende Magnetfeld den Polarisationszustand des Lichts beeinflußt, dessen Weg durch den Kern einer optischen Faser (2) führt, die den Leiter (1) in Form einer Wicklung (3) umgibt, wobei das aus der optischen Faser (2) ausgekoppelte Licht durch einen Strahlteiler (9) in zwei Teillichtstrahlen aufgeteilt wird, deren Intensitäten ($I_1$, $I_2$) nach Durchlaufen je eines Polarisators (12, 11) mit je einem Photodetektor (14, 13) gemessen werden, dadurch gekennzeichnet, daß die Polarisatoren (12, 11) symmetrisch zueinander gegenüber dem herkömmlichen Winkel von 45° verdreht sind.

2. Faseroptische Anordnung nach Anspruch 1, dadurch gekennzeichnet, daß der Winkel ($\alpha$) zwischen den Polarisatoren (12, 11) und der Polarisationsebene des in die optische Faser (2) eingekoppelten Lichts zwischen +20° und +40° bzw. zwischen -20° und -40° liegt.

## Claims

1. A fibre optics arrangement for measuring the strength of an electric current using the Faraday effect, wherein the magnetic field surrounding the current-carrying conductor (1) influences the polarization state of the light, the path of which leads through the core of an optical fibre (2) which surrounds the conductor (1) in the form of a winding (3), wherein the light output-coupled from the optical fibre (2) is split by a beam splitter (9) into two partial light beams, the intensities ($I_1$, $I_2$) of which, following passage through a respective polarizer (12, 11), are measured by a respective photodetector (14, 13), characterised in that the polarizers (12, 11) are rotated symmetrically to one another in relation to the conventional angle of 45°.

2. A fibre optics arrangement as claimed in Claim 1, characterised in that the angle ($\alpha$) between the polarizer (12, 11) and the polarization plane of the light input-coupled into the optical fibre (2) is between +20° and +40° and between -20° and -40° respectively.

## Revendications

1. Dispositif à fibres optiques pour mesurer l'intensité d'un courant électrique en utilisant l'effet Faraday, dans lequel le champ magnétique entourant le conducteur (1) parcouru par le courant influence l'état de polarisation de la lumière, dont le chemin passe par le coeur d'une fibre optique (2), qui entoure le conducteur (1) sous la forme d'un enroulement (3), la lumière découplée à partir de la fibre optique (2) par une lame séparatrice (9) étant divisée en deux rayons partiels de lumière, dont les intensités ($I_1$, $I_2$) sont mesurées après le passage de chacun à travers un polariseur (12, 11) chacun par un photodétecteur (14, 13), dispositif à fibres optiques caractérisé en ce que les polariseurs (12, 11) sont tournés symétriquement l'un par rapport à l'autre d'un autre angle que l'angle habituel de 45°.

2. Dispositif à fibres optiques selon la revendication 1, caractérisé en ce que l'angle ($\alpha$) compris entre les polariseurs (12, 11) et le plan de polarisation de la lumière entrant dans la fibre optique (2) se trouve entre +20° et +40° ou entre -20 et -40°.

EP 0 523 048 B1

# FIG.1

# FIG.2